# EUROPEAN PATENT SPECIFICATION

(11) **EP 3 504 797 B1**
(45) Date of publication and mention of the grant of the patent: **19.08.2020**
(21) Application number: 17742221.9
(22) Date of filing: 17.07.2017
(51) Int. Cl.: F16H 63/48, H03K 17/968, F16H 59/10, H03M 1/28, G01D 5/347

(54) **ACTUATING DEVICE FOR A PARKING LOCK**
BETÄTIGUNGSVORRICHTUNG FÜR EINE PARKSPERRE
DISPOSITIF D'ACTIONNEMENT POUR UN VERROUILLAGE DE STATIONNEMENT

(30) Priority: 23.08.2016 DE 102016215790
(43) Date of publication of application: 03.07.2019
(73) Proprietor: ZF Friedrichshafen AG, 88046 Friedrichshafen (DE)
(72) Inventor: KIRILENKO, Alexander, 49356 Diepholz (DE); HESSEL, Alex, 49448 Lemförde (DE); AUMANN, Torsten, 49406 Drentwede (DE)
(74) Representative: ZF Friedrichshafen AG
(86) International application number: PCT/EP2017/067984
(87) International publication number: WO 2018/036722

(56) References cited:
- WO-A1-03/081088
- DE-A1- 19 748 131
- DE-A1-102009 028 128
- DE-A1-102012 206 417
- DE-U1- 29 817 668
- JP-A- 2007 132 387
- US-A1- 2004 035 237

## Description

The invention relates to an actuating device for selecting a gear of a shift-by-wire gearshift transmission, the actuating device comprising a housing, a selection lever movable along at least one shift gate between at least a first position and a parking lock position, a mechanical transfer element for transferring this movement of the selection lever to the gearshift transmission for actuating the parking lock, a coupling system arranged between the selection lever and the transfer element, wherein the coupling system comprises a slider element embodied to move in accordance with the movement of the selection lever.

Such actuating devices are used in passenger vehicles, for example, for controlling the transmission of the vehicle. While the gear of the transmission is increasingly controlled by transmitting electrical signals to actuators that mechanically act on the transmission, the parking lock, in contrast, is often controlled via a direct mechanical connection between the actuating device and the transmission. This has the advantage that in a situation where no energy is available for the electrical actuators in the transmission, the vehicle can still be locked into a park position, or freed from a park-locked state when the vehicle is defective, for example, so that it can be towed. However, the current state of the park lock mechanism must be monitored so that the shift-by-wire system can prevent the electrically controlled actuators from engaging a drive gear while the vehicle is in a park-locked state, for example.

The position of the selection lever of such an actuation device has traditionally been monitored with a variety of sensor arrangements. For example, the German patent publications DE29817668 and DE19748131C2 disclose optical means for detecting the position of a shifting lever, by using a sensor arrangement comprising laser diodes, an optical fiber bundle and/or a photosensitive device, wherein the light structure transmitted and received is dependent on the position of the shifting lever. DE102009028128 discloses actuating device for selecting a gear. US2004035237, JP2007132387, WO03081088 and DE102012206417 disclose further relevant state of the art arrangements.

It can, however, be advantageous to monitor the state of the park actuator with a separate sensor arrangement that is independent from the sensor arrangement used to monitor the position of the selection lever. This can be advantageous for the sake of redundancy, or because in some actuation devices, the selection lever can be decoupled from the slider element in certain selection positions.

It is the object of the invention to provide an actuating device with a reliable arrangement for monitoring the state of the parking lock actuator.

The object is achieved by the device according to claim 1. Advantageous further developments of the actuating device are outlined in the dependent claims.

The object is therefore achieved by an actuating device for selecting a gear of a shift-by-wire gearshift transmission, the actuating device comprising a housing, a selection lever movable along at least one shift gate between at least a first position and a parking lock position, a mechanical transfer element for transferring said movement of the selection lever to the gearshift transmission for actuating the parking lock, a coupling system arranged between the selection lever and the transfer element, wherein the coupling system comprises a slider element embodied to move in accordance with said movement of the selection lever, wherein the actuating device comprises a optical sensor arrangement, arranged within the housing and comprising at least one transmitter/receiver pair, wherein the slider element comprises a window structure such that when the slider element is in the first position, the slider element interrupts an electromagnetic signal emitted from the transmitter or passes the electromagnetic signal through the window structure, and when the slider element is in the parking lock position, the slider element respectively passes the electromagnetic signal through the window structure or interrupts the electromagnetic signal.

The receiver therefore receives a signal in only one of the positions, thereby providing criteria for determining the current position of the slider element.

In an advantageous embodiment of the inventive actuating device, the transmitter/receiver pair is embodied to transmit and receive infrared electromagnetic signals.

In an embodiment of the inventive actuating device, the transfer element is a Bowden cable. Alternatively, the transfer element can be embodied as a rod.

In an advantageous embodiment the window structure is formed by a wall of the slider element arranged essentially along the direction of the movement of the slider element, wherein the wall comprises openings. The wall can be formed integrally with the slider element. This can be advantageous for the production of such a slider element as the wall with the openings, or windows, can be produced in a single injection molding process with a corresponding form.

In an embodiment of the actuating device the transmitter/receiver pair is embodied as an optical fork. In a further development of the embodiment, the optical fork is arranged on a printed circuit board and the slider element is embodied to move relative to the printed circuit board, such that the wall is positioned between the transmitter and receiver of the optical fork. The printed circuit board can be mounted such that it has a fixed position with respect to the housing, for example by being attached to an inside wall of the housing. The movement of the slider with respect to the transmission can thereby be monitored, as the housing is generally mounted within a vehicle in a fixed position with respect to the transmission.

In a further development the optical sensor arrangement comprises at least two transmitter/receiver pairs, and the window structure is arranged such that at each position of the slider element a unique combination of passed and/or interrupted electromagnetic signals arises. The optical sensor arrangement, when comprising a plurality of transmitter/receiver pairs has the capability to monitor more than two positions of the slider element. The number of positions that can be monitored is limited by the number of unique sensor outputs, which can be calculated using the formula P = 2^n, where P is the number of positions and n is the number of transmitter/receiver pairs.

In an embodiment of the actuating device at least one analog to digital converter is provided to convert an output of the optical sensor arrangement into a bit code, wherein the window structure and position of the pairs is arranged so that the hamming distance between bit codes that represent different positions of the slider element has a value of at least two. This advantageously increases the reliability of the sensor arrangement and the actuation device, since the malfunction of a single transmitter or receiver results in a digital output corresponding to a unassigned bit code. That is, the combined output of the transmitter/receiver pairs that is registered, i.e. read from the bit code, will correspond to a physically impossible combination of passed and blocked signals.

In an embodiment of the actuating device, the actuating device comprises an evaluation unit, which is embodied to receive the output of the optical sensor arrangement and to determine the position of the slider element on the basis of the output of the optical sensor arrangement.

An embodiment of the invention will next be explained in detail with reference to the following figures. They show:
Fig. 1: a perspective view of an actuating device with a slider element and printed circuit board according to an embodiment of the actuating device;
Fig. 2: a top view of the slider element in four positions (A, B, C, E) relative to the printed circuit board according to the embodiment shown in Fig. 1, as well as tables that display a binary output corresponding to each of the positions.

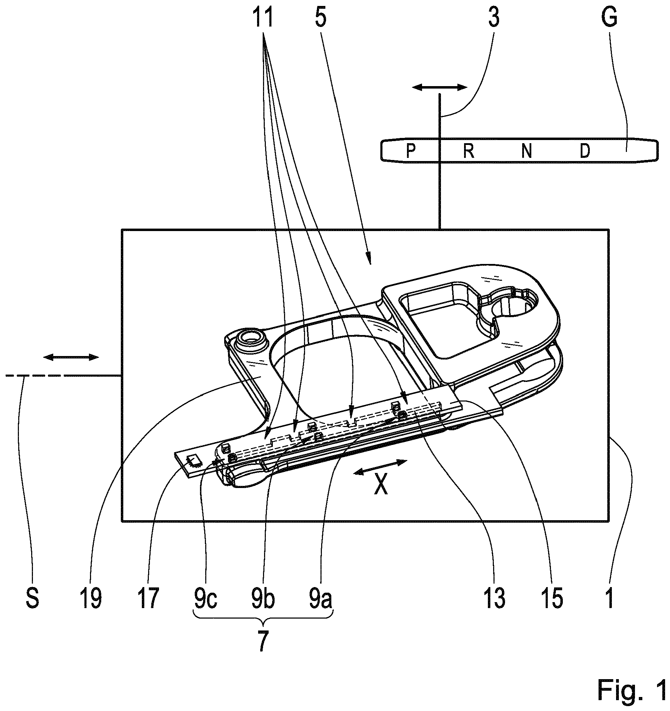

Fig. 1 shows a perspective view of a slider element 5 and printed circuit board 15 according to an embodiment of the actuating device. The slider element 5 comprises a window structure 11. The window structure 11 is formed by a wall 13 arranged along a direction of movement X of the slider element 5. The wall 13 is arranged between the base 19 of the slider element 5 and a printed circuit board 15. The wall 13 comprises openings 11a, 11b, 11c, 11d along the top edge, which faces the printed circuit board 15. These openings 11a, 11b, 11c, 11d serve as windows, which permit infrared signals to pass through the wall 13. The infrared signals are generated and transmitted by infrared transmitter components 9at, 9bt, 9ct, which are arranged on the printed circuit board 15 in a row essentially parallel to the wall 13. Arranged opposite to the transmitter components 9at, 9bt, 9ct are receiver components 9ar, 9br, 9cr, such that each transmitter is paired with a receiver. The receiver components 9ar, 9br, 9cr are also arranged in a row essentially parallel to the wall 13, i.e. essentially parallel to the direction of movement X of the slider element 5. The transmitter/receiver pairs 9a, 9b, 9c can be considered to be optical, or infrared, fork sensors.

The printed circuit board 15 is mounted within the actuating device so as to be stationary with respect to the housing 1 of the actuating device, whereas the slider element 5 is embodied to be movable with respect to the housing 1 and also therefore with respect to the printed circuit board 15. The wall 13 therefore moves along the direction of movement X of the slider element 5, such that the openings 11a, 11b, 11c, 11d in wall 13 at certain points along the movement of the slider element 5 are positioned so as to permit infrared signals to pass between the transmitter 9at, 9bt, 9ct and receiver 9ar, 9br, 9cr of a respective infrared fork sensor.

The slider element 5 is connectable to a selection lever 3 of the actuating device, wherein the selection lever 3, and therefore also the slider element 5, has four stable positions. For a gear selection lever 3, these positions can be labeled as Park P, Neutral N, Reverse R and Drive D, for example. The window structure 11 comprised by the slider element 5 is arranged so that a certain combination of passed and blocked signals arises when the selection lever 3, and correspondingly the slider element 5, is at a stable location, wherein the combination for each position differs from the combination that arises at a different position, that is, the combination of signals passed and blocked is unique for each position.

In the position shown in Fig. 1, the signal transmitted by a first transmitter component 9st of a first transmitter/receiver pair 9a is not blocked by the wall 13. The signal transmitted by a second transmitter 9bt of a second transmitter/receiver pair 9b however blocked. In contrast, the receiver component 9cr of the third transmitter/receiver pair 9c receives a signal that is permitted to pass through the wall, since an opening of the wall is located between the transmitter 9ct and the receiver 9cr components at this position.

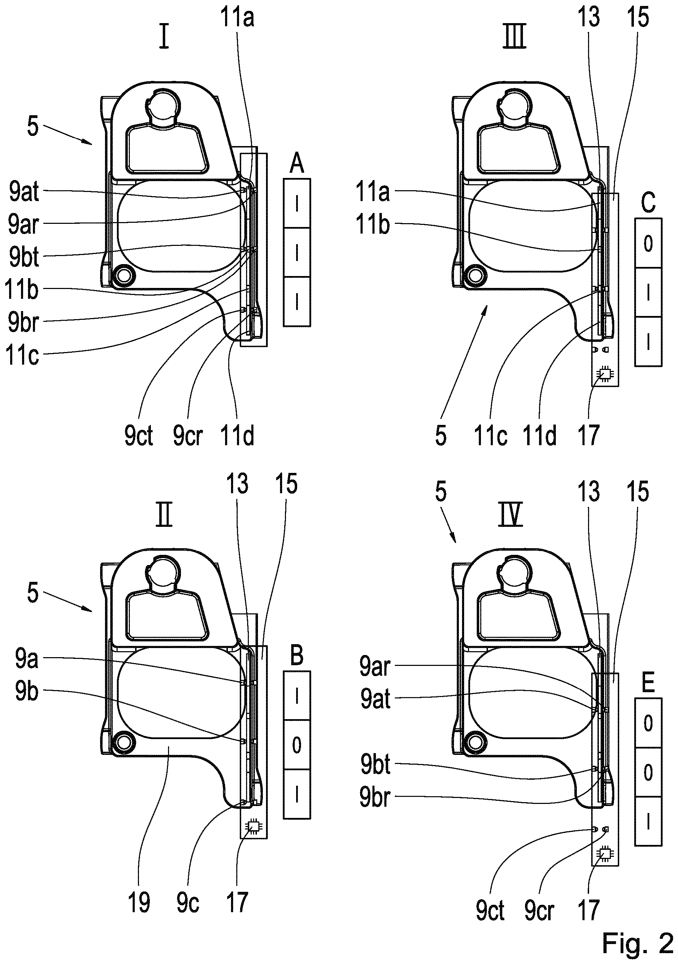

In Fig. 2 a top view of the slider element 5 is shown. The slider element 5 is depicted in four positions A, B, C, E relative to the printed circuit board 15 and the respective infrared fork sensors 9a, 9b, 9c according to the embodiment shown in Fig. 1. Fig. 2 is divided into four quadrants I, II, III, IV, which show respectively one of the four positions A, B, C, E. Furthermore, tables that display a binary output of the sensor pairs 9a, 9b, 9c is shown for each of the positions A, B, C, E in each of the quadrants I, II, III, IV.

In a first position A, as shown in a the first quadrant I, the wall is positioned such that a first opening 11a is located between the first transmitter/receiver pair 9a, a second opening 11b is located between the second transmitter/receiver pair 9b, and a fourth opening 11d is located between the third transmitter/receiver pair 9c. Each receiver 9ar, 9br, 9cr therefore registers an infrared signal and outputs a corresponding signal to an analog to digital converter (A/D). The A/D-converter is either comprised in an evaluation unit 17 or is electronically connected to an evaluation unit 17. The signal incident on the sensors 9ar, 9br, 9cr raises the electrical output to the A/D-converter above a predetermined reference level, so that the A/D-converter outputs a value of 1 to the evaluation unit 17, or to other components of the evaluation unit 17 if the A/D-converter is comprised by the evaluation unit 17. Since each of the transmitter/receiver pairs 9a, 9b, 9c is able to pass an infrared signal through the window structure 11 in the first position A the binary output for each of the sensors in the evaluation unit is 1. Therefore the first position A is characterized by, or corresponds to, the binary code 111.

In the second position B, as shown in the second quadrant II, the first opening continues 11a to be positioned between the first transmitter/receiver pair 9a. However, a portion of the wall 13 that does not comprise an opening is arranged between the second transmitter/receiver pair 9b. Therefore, an infrared signal transmitted from the second transmitter 9bt is prevented from reaching the second receiver 9br and consequently, the binary output of the second receiver 9br to the evaluation unit is 0. The third pair passes a signal from the transmitter 9ct to the receiver 9cr, since the fourth opening 11d in the wall 13 is still positioned along the signal path between the third transmitter 9ct and receiver 9cr. The binary output of the transmitter/receiver pairs 9a, 9b, 9c when the slider element 5 is in the second position B is therefore 101.

When the slider element 5 is in a third position C, as shown in the third quadrant III, the wall 13 is arranged to block the infrared signal transmitted from the first transmitter 9at so that no signal is incident on the first receiver 9ar. The output of the first sensor 9a is therefore 0. In contrast, an opening 11c is positioned between the second transmitter/receiver pair 9b, and the third transmitter/receiver pair 9c is beyond the reach of the wall so that the outputs of the second and third receiver 9br, 9cr are interpreted by the evaluation unit 17 as being respectively 1 and 1. The total binary output of the group of sensors, i.e. transmitter/receiver pairs 9a, 9b, 9c, is consequently 011. This output can be compared to a list saved in a memory unit of the evaluation unit 17, for example, in order to determine that the slider element 5 is currently in the third position C.

In the fourth quadrant IV, the slider element 5 is shown in a fourth position E. Here, the wall 13 of the slider element 5 is positioned to intercept signals emitted from the first and second transmitters 9at, 9bt. The third transmitter/receiver pair 9c registers a signal, being located beyond the extent of the wall 13. The binary output of the transmitter/receiver pairs 9a, 9b, 9c is therefore 001. A subsequent evaluation by the evaluation unit 17 can determine based on this output that the slider element 5 is in the fourth position E.

The four expected outputs of the system 7 of transmitters and receivers 9a, 9b, 9c are therefore: 111, 101, 011 and 001. If for example, the evaluation unit 17 would register an output of the transmitter/receiver pairs 9a, 9b, 9c as being 110, an error message could be output to warn an operator of a (passenger-) vehicle or to a central processing unit of the vehicle.

### Reference Characters

- 1: housing
- 3: selection lever
- 5: slider element
- 7: optical sensor system
- 9ar/-t, 9br/-t, 9cr/-t: first, second and third transmitter/receiver pairs
- 11a, b, c, d: first, second, third and fourth openings
- 13: wall
- 15: printed circuit board
- 17: evaluation unit
- 19: base of slider element
- A, B, C, E: first to fourth positions of slider element
- P, R, N, D: positions of selection lever
- G: shift gate
- S: transfer element/ Bowden cable

## Claims

1. Actuating device for selecting a gear of a shift-by-wire gearshift transmission, the actuating device comprising a housing (1), a selection lever (3) movable along at least one shift gate (G) between at least a driving position (R, N, D) and a parking lock position (P),
a mechanical transfer element (S) for transferring said movement of the selection lever (3) to the gearshift transmission for actuating the parking lock, a coupling system arranged between the selection lever (3) and the transfer element (S), wherein the coupling system comprises a slider element (5) embodied to move in accordance with said movement of the selection lever (3), **characterized in that** the actuating device comprises an optical sensor arrangement (7), arranged within the housing (1) and comprising at least one transmitter/receiver pair (9a, 9b, 9c), wherein the slider element (5) comprises a window structure (11) such that when the slider element (5) is in a first position (A, B, C, E) corresponding to a driving position of the selection lever (3), the slider element (5) is configured to interrupt an electromagnetic signal emitted from the transmitter (9at, 9bt, 9ct) or to pass the electromagnetic signal through the window structure (11), and when the slider element (5) is in a second position (A, B, C, E) corresponding to the parking lock position of the selection lever (3), the slider element (5) respectively is configured to pass the electromagnetic signal through the window structure (11) or to interrupt the electromagnetic signal.

2. Actuating device according to claim 1, wherein the at least one transmitter/receiver pair (9a, 9b, 9c) is embodied to transmit and receive infrared electromagnetic signals.

3. Actuating device according to claim 1 or 2, wherein the transfer element (S) is a Bowden cable.

4. Actuating device according to at least one of the previous claims, **characterized in that** the window structure (11) is formed by a wall (13) of the slider element (5) arranged essentially along the direction of the movement of the slider element, wherein the wall comprises openings (11a, 11b, 11c, 11d).

5. Actuating device according to at least one of the previous claims, **characterized in that** the at least one transmitter/receiver pair (9a, 9b, 9c) is embodied as an optical fork.

6. Actuating device according to claim 5, wherein the optical fork is arranged on a printed circuit board (15) and wherein the slider element (5) is embodied to move relative to the printed circuit board (15), such that the wall (13) is positioned between the transmitter (9at, 9bt, 9ct) and receiver (9ar, 9br, 9cr) of the optical fork.

7. Actuating device according to at least one of the previous claims, **characterized in that** the optical sensor arrangement (7) comprises at least two transmitter/receiver pairs (9a, 9b, 9c), and **in that** the window structure (11) is arranged such that at each position (A, B, C, D) of the slider element (5) a unique combination of passed and/or interrupted electromagnetic signals arises.

8. Actuating device according to at least one of the previous claims, **characterized in that** at least one analog to digital converter (A/D) is provided to convert an output of the optical sensor arrangement (7) into a bit code.

9. Actuating device according to claim 8, **characterized in that** the window structure (11) and the positioning of the at least two transmitter/receiver pairs (9a, 9b, 9c) is arranged so that the hamming distance between bit codes that represent different positions (A, B, C, E) of the slider element (5) has a value of at least two.

10. Actuating device according to at least one of the previous claims, wherein the actuating device comprises an evaluation unit (17), which is embodied to receive the output of the optical sensor arrangement (7) and to determine the position (A, B, C, E) of the slider element (5) on the basis of the output of the optical sensor arrangement (7).

## Patentansprüche

1. Betätigungsvorrichtung zum Wählen eines Gangs eines Shift-By-Wire-Gangschaltgetriebes, wobei die Betätigungsvorrichtung ein Gehäuse (1), einen Wählhebel (3), der entlang mindestens einer Schaltgasse (G) zwischen mindestens einer Fahrposition (R, N, D) und einer Parksperrenposition (P) bewegbar ist,
ein mechanisches Übertragungselement (S) zum Übertragen der Bewegung des Wählhebels (3) auf das Gangschaltgetriebe zum Aktivieren der Parksperre, ein Kupplungssystem, das zwischen dem Wählhebel (3) und dem Übertragungselement (S) angeordnet ist, wobei das Kupplungssystem ein Schieberelement (5) umfasst, das ausgeführt ist, sich gemäß der Bewegung des Wählhebels (3) zu bewegen, umfasst, **dadurch gekennzeichnet, dass** die Betätigungsvorrichtung eine optische Sensoranordnung (7) umfasst, die in dem Gehäuse (1) angeordnet ist und mindestens ein Sender-/Empfänger-Paar (9a, 9b, 9c) umfasst, wobei das Schieberelement (5) eine Fensterstruktur (11) umfasst, sodass, wenn sich das Schieberelements (5) in einer einer Fahrposition des Wählhebels (3) entsprechenden ersten Position (A, B, C, E) befindet, das Schieberelement (5) ausgestaltet ist, ein von dem Sender (9at, 9bt, 9ct) ausgegebenes elektromagnetisches Signal zu unterbrechen oder das elektromagnetische Signal durch die Fensterstruktur (11) weiterzuleiten, und wenn sich das Schieberelement (5) in einer der Parksperrenposition des Wählhebels (3) entsprechenden zweiten Position (A, B, C, E) befindet, das Schieberelement (5) jeweils ausgestaltet ist, das elektromagnetische Signal durch die Fensterstruktur (11) weiterzuleiten oder das elektromagnetische Signal zu unterbrechen.

2. Betätigungsvorrichtung nach Anspruch 1, wobei das mindestens eine Sender-/Empfänger-Paar (9a, 9b, 9c) ausgeführt ist, elektromagnetische Infrarotsignale zu senden und zu empfangen.

3. Betätigungsvorrichtung nach Anspruch 1 oder 2, wobei das Übertragungselement (S) ein Bowdenzug ist.

4. Betätigungsvorrichtung nach mindestens einem der vorhergehenden Ansprüche, **dadurch gekennzeichnet, dass** die Fensterstruktur (11) durch eine Wand (13) des Schieberelements (5) gebildet ist, die im Wesentlichen entlang der Bewegungsrichtung des Schieberelements angeordnet ist, wobei die Wand Öffnungen (11a, 11b, 11c, 11d) umfasst.

5. Betätigungsvorrichtung nach mindestens einem der vorhergehenden Ansprüche, **dadurch gekennzeichnet, dass** das mindestens eine Sender-/Empfänger-Paar (9a, 9b, 9c) als eine optische Gabel ausgeführt ist.

6. Betätigungsvorrichtung nach Anspruch 5, wobei die optische Gabel auf einer Leiterplatte (15) angeordnet ist und wobei das Schieberelement (5) ausgeführt ist, sich in Relation zu der Leiterplatte (15) derart zu bewegen, dass die Wand (13) zwischen dem Sender (9at, 9bt, 9ct) und dem Empfänger (9ar, 9br, 9cr) der optischen Gabel positioniert ist.

7. Betätigungsvorrichtung nach mindestens einem der vorhergehenden Ansprüche, **dadurch gekennzeichnet, dass** die optische Sensoranordnung (7) mindestens zwei Sender-/Empfänger-Paare (9a, 9b, 9c) umfasst, und dass die Fensterstruktur (11) derart angeordnet ist, dass an jeder Position (A, B, C, D) des Schieberelements (5) eine eindeutige Kombination aus weitergeleiteten und/oder unterbrochenen elektromagnetischen Signalen entsteht.

8. Betätigungsvorrichtung nach mindestens einem der vorhergehenden Ansprüche, **dadurch gekennzeichnet, dass** mindestens ein Analog-Digital-Wandler (A/D) bereitgestellt ist, um eine Ausgabe der optischen Sensoranordnung (7) in einen Bitcode umzuwandeln.

9. Betätigungsvorrichtung nach Anspruch 8, **dadurch gekennzeichnet, dass** die Fensterstruktur (11) und die Positionierung der mindestens zwei Sender-/Empfänger-Paare (9a, 9b, 9c) derart angeordnet ist, dass der Hamming-Abstand zwischen Bitcodes, die unterschiedliche Positionen (A, B, C, E) des Schieberelements (5) darstellen, einen Wert von mindestens zwei aufweist.

10. Betätigungsvorrichtung nach mindestens einem der vorhergehenden Ansprüche, wobei die Betätigungsvorrichtung eine Auswerteeinheit (17) umfasst, die ausgeführt ist, die Ausgabe der optischen Sensoranordnung (7) zu empfangen und die Position (A, B, C, E) des Schieberelements (5) auf der Basis der Ausgabe der optischen Sensoranordnung (7) zu bestimmen.

## Revendications

1. Dispositif d'actionnement servant à sélectionner un engrenage d'une boîte de vitesses à commande électrique du changement de vitesses, le dispositif d'actionnement comprenant un boîtier (1), un levier de sélection (3) mobile le long d'au moins une porte de changement de vitesses (G) entre au moins une position de conduite (R, N, D) et une position de verrouillage de stationnement (P),
un élément de transfert mécanique (S) pour transférer ledit mouvement du levier de sélection (3) à la boîte de vitesses pour actionner le verrouillage de stationnement, un système d'accouplement disposé entre le levier de sélection (3) et l'élément de transfert (S), le système d'accouplement comprenant un élément coulissant (5) conçu pour se déplacer en fonction dudit mouvement du levier de sélection (3), **caractérisé en ce que** le dispositif d'actionnement comprend un ensemble capteur optique (7), disposé à l'intérieur du boîtier (1) et comprenant au moins une paire d'émetteurs/récepteurs (9a, 9b, 9c), dans lequel l'élément coulissant (5) comprend une structure de fenêtre (11) telle que lorsque l'élément coulissant (5) est dans une première position (A, B, C, E) correspondant à une position de conduite du levier de sélection (3), l'élément coulissant (5) est conçu pour interrompre un signal électromagnétique émis par l'émetteur (9at, 9bt, 9ct) ou pour faire passer le signal électromagnétique à travers la structure de fenêtre (11), et lorsque l'élément coulissant (5) est dans une seconde position (A, B, C, E) correspondant à la position de verrouillage de stationnement du levier de sélection (3), l'élément coulissant (5) est respectivement conçu pour faire passer le signal électromagnétique à travers la structure de fenêtre (11) ou pour interrompre le signal électromagnétique.

2. Dispositif d'actionnement selon la revendication 1, dans lequel l'au moins une paire d'émetteurs/récepteurs (9a, 9b, 9c) est conçue pour émettre et recevoir des signaux électromagnétiques infrarouges.

3. Dispositif d'actionnement selon la revendication 1 ou 2, dans lequel l'élément de transfert (S) est un câble Bowden.

4. Dispositif d'actionnement selon au moins l'une des revendications précédentes, **caractérisé en ce que** la structure de fenêtre (11) est formée par une paroi (13) de l'élément coulissant (5) disposée essentiellement le long de la direction du mouvement de l'élément coulissant, dans lequel la paroi comprend des ouvertures (11a, 11b, 11c, 11d).

5. Dispositif d'actionnement selon au moins l'une des revendications précédentes, **caractérisé en ce que** l'au moins une paire d'émetteurs/récepteurs (9a, 9b, 9c) est conçue sous la forme d'une fourche optique.

6. Dispositif d'actionnement selon la revendication 5, dans lequel la fourche optique est disposée sur une carte de circuit imprimé (15) et dans lequel l'élément coulissant (5) est conçu pour se déplacer par rapport à la carte de circuit imprimé (15), de sorte que la paroi (13) est positionnée entre l'émetteur (9at, 9bt, 9ct) et le récepteur (9ar, 9br, 9cr) de la fourche optique.

7. Dispositif d'actionnement selon au moins l'une des revendications précédentes, **caractérisé en ce que** l'ensemble capteur optique (7) comprend au moins deux paires d'émetteurs/récepteurs (9a, 9b, 9c), et **en ce que** la structure de fenêtre (11) est agencée de telle sorte qu'à chaque position (A, B, C, D) de l'élément coulissant (5), une combinaison unique de signaux électromagnétiques passés et/ou interrompus se produit.

8. Dispositif d'actionnement selon au moins l'une des revendications précédentes, **caractérisé en ce qu'**au moins un convertisseur analogique-numérique (A/N) est prévu pour convertir une sortie de l'ensemble capteur optique (7) en un code binaire.

9. Dispositif d'actionnement selon la revendication 8, **caractérisé en ce que** la structure de fenêtre (11) et le positionnement des au moins deux paires d'émetteurs/récepteurs (9a, 9b, 9c) sont disposés de telle sorte que la distance de hamming entre les codes binaires qui représentent différentes positions (A, B, C, E) de l'élément coulissant (5) a une valeur d'au moins deux.

10. Dispositif d'actionnement selon au moins l'une des revendications précédentes, le dispositif d'actionnement comprenant une unité d'évaluation (17), qui est conçue pour recevoir la sortie de l'ensemble capteur optique (7) et pour déterminer la position (A, B, C, E) de l'élément coulissant (5) sur la base de la sortie de l'ensemble capteur optique (7).
